# EUROPÄISCHE PATENTSCHRIFT

(11) **EP 0 697 466 B1**
(45) Veröffentlichungstag und Bekanntmachung des Hinweises auf die Patenterteilung: **01.04.1998**
(21) Anmeldenummer: 95111115.2
(22) Anmeldetag: 15.07.1995
(51) Int. Cl.: C23C 16/44, C23C 14/50, C23C 14/04, C23C 16/04

(54) **Vorrichtung und Verfahren zur partiellen Beschichtung von Bauteilgruppen**
Apparatus and method for partial coating of groups of substrates
Appareil et procédé pour le revêtement partiel d'un ensemble de substrats

(30) Priorität: 22.07.1994 DE 4425991
(43) Veröffentlichungstag der Anmeldung: 21.02.1996
(73) Patentinhaber: MTU MOTOREN- UND TURBINEN-UNION MÜNCHEN GMBH, 80976 München (DE)
(72) Erfinder: Eichmann, Wolfgang, D-82178 Puchheim (DE); Thoma, Martin, Dr., D-80802 München (DE); Pillhöfer, Horst, D-85244 Röhrmoos (DE); Hartung, Johannes, D-01324 Dresden (DE); Helling, Karl-Heinz, D-01324 Dresden (DE)

(56) Entgegenhaltungen:
- DE-C- 925 689
- GB-A- 515 148
- GB-A- 2 008 156
- US-A- 3 979 273
- US-A- 4 252 626
- US-A- 4 271 005
- US-A- 4 828 668
- PATENT ABSTRACTS OF JAPAN vol. 014 no. 559 (C-0787) ,12.Dezember 1990 & JP-A-02 240261 (SUMITOMO METAL IND LTD) 25.September 1990,

## Beschreibung

Die Erfindung betrifft eine Vorrichtung zur partiellen Beschichtung von Bauteilen, die zu Gruppen in einer Reaktionskammer mit Blenden so angeordnet sind, daß nicht zu beschichtende Bauteiloberflächen vor dem Beschichtungsmedium durch die Blenden geschützt sind und ein Verfahren zum partiellen Beschichten.

Derartige Vorrichtungen und Verfahren sind als Aufdampf-, Gasdiffusions-, Plasmaspritz- oder Aufstäubungsanlagen und -verfahren bekannt. Dabei können die bekannten Vorrichtungen drehbare Teller aufweisen, auf denen ihrerseits Untergruppen oder Einzelbauteile auf drehbaren Untertellern stehen. Die drehbaren Unterteller sorgen für eine gleichmäßige Beschichtung einer Untergruppe oder eines Einzelbauteils und der drehbare Teller ermöglicht, die Untergruppe oder das Einzelbauteil in unterschiedliche Stationen der Beschichtungsvorrichtung zu fahren. Für eine partielle Beschichtung müssen die nicht zu beschichtenden Oberflächen eines Bauteils mit kostenintensivem Aufwand durch Blenden oder Schutzbeschichtungen oder Masken abgedeckt werden. Diese Beschichtungsvorrichtungen und -verfahren haben den Nachteil eines hohen Verbrauchs an Beschichtungsmaterial, da sowohl die Blenden als auch die Abdeckungen und die großflächigen Wände der Beschichtungsanlage mitbeschichtet werden und folglich eine Rückgewinnung des Beschichtungsmaterials mit hohem technischen und Kostenaufwand verbunden ist, zumal die großflächigen Wände und Blenden nur äußerst dünne Beschichtungen aufweisen.

Insbesondere wirken sich diese Nachteile bei der Beschichtung von Triebwerksschaufeln mit Edelmetallen aus. Aus Festigkeitsgründen dürfen Triebwerksschaufeln für eine Rotorscheibe nicht im Fußbereich und nicht auf der Plattformunterseite, die sich unmittelbar an den Fußbereich anschließt, beschichtet werden. Der Fußquerschnitt seinerseits weist ein komplexes Tannenbaumprofil auf und kann nur mittels aufwendig hergestellter Masken vor einer Beschichtung geschützt werden. Weisen darüber hinaus die Triebwerksschaufeln Deckbandsegmente auf, so ist es aus Festigkeits und Passungsgründen erforderlich, die Beschichtung partiell nur auf die Oberflächen aufzubringen, die den Gasen des Strömungkanals des Triebwerks ausgesetzt sind. Neben der beträchtlichen Menge an Beschichtungsmaterial, das verlustreich auf den Maskierungsflächen abgeschieden wird, entstehen zusätzliche Streuverluste durch Beschichten von Anlagenkomponenten.

Aufgabe der Erfindung ist es, eine Vorrichtung und ein Verfahren anzugeben, mit denen die Verluste an Beschichtungsmaterial eingeschränkt und eine wirtschaftliche Rückgewinnung von Beschichtungsmaterial begünstigt wird. Außerdem soll eine reproduzierbar gleichmäßige Beschichtungsdicke auf den partiell zu beschichtenden Bauteiloberflächen erreicht werden, ohne daß Beschichtungsmaterial die verbleibenden Bauteiloberflächen erreicht.

Diese Aufgabe wird durch die Merkmale des Gegenstands nach Anspruch 1 und durch die Merkmale und Verfahrensschritte des Verfahrens nach Anspruch 17 gelöst.

Der Vorteil der erfindungsgemäßen Lösung nach Anspruch 1 ist, daß ein aktiver mit Beschichtungsmedium anreicherbarer Reaktionsraum äußerst klein gehalten wird und im wesentlichen aus Wänden besteht, die von zu beschichtenden Öberflächen gebildet werden, so daß Streuverluste minimiert werden. Soweit Blenden als Wände des aktiven Reaktionsraumes erforderlich sind, sind diese derart nahe an den Beschichtungsquellen und zu beschichtenden Oberflächen angeordnet, daß auf ihnen Beschichtungen entstehen, die vorteilhaft hohe Schichtdicken bei gleichzeitig minimaler Fläche ausbilden, so daß eine wirtschaftlich vertretbare Rückgewinnung des Beschichtungsmaterials durchführbar ist.

Durch die Anordnung der Bauteile auf dem Außenumfang eines um seine Achse drehbaren Rades, wobei die nicht zu beschichtenden Oberflächen der Bauteile durch das Rad verdeckt sind und die zu beschichtenden Oberflächenbereiche der Bauteile aus dem Rad radial herausragen, wird vorteilhaft erreicht, daß einerseits die Größe des aktiven Reaktionsraumes auf den Zwischenraum zwischen zwei oder drei benachbarten Bauteilen vermindert werden kann und andererseits ein zügiges Durchtakten oder Durchfahren aller Bauteile einer Bauteilgruppe durch den aktiven Reaktionsraum ermöglicht wird. Ferner wird erreicht, daß damit auch der Vorteil verbunden ist, daß die Abschirmung der von Beschichtungsmaterial freizuhaltenden Oberflächen im wesentlichen einfach und effektiv vom Rad übernommen wird. Eine Maskierung, Ummantelung oder das Aufbringen einer Schutzbeschichtung für die vor Beschichtungsmaterial zu schützenden Oberflächen entfallen und werden von einem einfachen Einschieben oder Einstecken der Bauteile in das Rad ersetzt.

Bei abgewinkelten Bauteilen oder Bauteilen mit integralen Schürzen, Flanschansätzen, Mantel- oder Ringsegmenten können diese auf dem Rad so angeordnet werden, daß zu beschichtende Oberflächen der benachbarten Bauteile teilweise oder vollständig eine dritte Wand bilden. Vorzugsweise wird dazu der zweite Schenkel eines Winkels oder der Flansch oder das Mantel- bzw. Ringsegment auf dem Radumfang oder tangential zum Radumfang positioniert, so daß im Falle des Zusammenstoßens dieser integralen Bestandteile benachbarter Bauteile die dritte Wand des aktiven Reaktionsraumes vorteilhaft nicht von einem Abschnitt des Radumfangs sondern vollständig von zu beschichtenden Bauteiloberflächen gebildet wird, was vorteilhaft die Nutzflächen gegenüber den Streu- oder Blendenflächen des aktiven Reaktionsraums erhöht.

Vorzugsweise weist eine der verbleibenden Wände des aktiven Reaktionsraumes mindestens eine Heizquelle auf, die die zu beschichtenden Oberflächen auf eine Temperatur erwärmen kann, die einerseits ein Abdampfen von Kontaminationsmedien von den Oberflächen bei einer Vorreinigung ermöglicht und andererseits eine Vorwärmung der zu beschichtenden Oberflächen auf eine für die Haftung des Beschichtungsmediums auf den Oberflächen günstige Temperatur vorheizt. Während des Betriebs der Heizquelle kann mittels einer verstellbaren Blende die Beschichtungsquelle vor unerwünschter Kontamination geschützt werden. Andererseits kann vorteilhaft eine Reinigung (sputtercleaning) und Reinigungsätzung (sputteretching) mittels Inertgas-Ionenbeschuß durch die Beschichtungsquelle unter gleichzeitiger Vorheizung der zu beschichtenden Oberflächen durch die Heizquelle erfolgen. Mit dieser Heizquellenanordnung ist der Vorteil verbunden, daß unmittelbar nach dem Aufheizen der zu beschichtenden Oberflächen oder sogar während der Beheizung ein Beschichtungszyklus für dieselben Oberflächen durchführbar ist, und daß der aktive Reaktionsraum kompakt aufgebaut ist.

Andererseits ist es denkbar, daß die Heizquelle vorteilhaft zur Rückgewinnung von Beschichtungsmaterial zugeschaltet wird, wobei an Stelle benachbarter Bauelemente die Seitenwände des aktiven Reaktionsraums in einem Rückgewinnungszyklus von Kühlelementen mit Adsorptionsflächen für das auf den Blenden und dem Radumfangsabschnitt abgeschiedene Beschichtungsmaterial gebildet werden.

In einer bevorzugten Ausbildungsform der Vorrichtung ist auf mindestens einer der verbleibenden Wände des aktiven Reaktionsraumes mindestens ein Meßfühler angeordnet. Derartige Meßfühler dienen vorteilhaft der Messung der Beschichtungs- oder Reaktionstemperatur, der Messung der Beschichtungsrate oder der Messung von Beschichtungsdicken, wobei die Anordnung auf einer wandbildenden Blende den Vorteil hat, daß keine zusätzlichen Wandflächen erforderlich werden und damit der Reinigungs- oder Rückgewinnungsaufwand vermindert wird. Außerdem sind die Meßfühler damit vorteilhaft auf engstem Raum nahe am Beschichtungsvorgang positioniert, so daß Fehlmessungen minimiert werden.

Eine der verbleibenden Wände des aktiven Reaktionsraumes kann vorzugsweise mindestens eine Öffnung zur pyrometrischen Temperaturerfassung aufweisen. Diese Öffnung mit nachgeordneter pyrometrischer Temperaturerfassung ermöglicht vorteilhaft eine berührungslose Überwachung der Temperatur der Beschichtungsquelle oder der zu beschichtenden Oberflächen oder eventuell einer eingebauten Heizquelle. Die Öffnung kann äußerst klein gestaltet sein, so daß der Streuverlust des Beschichtungsmediums gering bleibt.

Eine weitere bevorzugte Ausbildungsform der Vorrichtung besteht darin, daß die Bauteile Triebwerksschaufeln sind. Diese Triebwerksschaufeln werden mit ihrem Fuß in einfache Aussparungen, die auf dem Umfang des Rades angeordnet sind, eingesetzt. Dabei wird ein Fuß unmittelbar am nächsten Fuß angeordnet, so daß einerseits kompliziert geformte und aufwendig installierte Masken zur Vermeidung der Beschichtung der Schaufelfüße und der Plattformunterseiten zwischen Schaufelfüßen und Schaufelblättern nicht erforderlich sind und andererseits eine gleichmäßige Beschichtung der Schaufelblätter und der Plattformoberseiten gewährleistet bleiben. Durch den in die Aussparungen des Radumfangs passenden Schaufelfuß ist die Triebwerksschaufel vor radialen Verschiebungen gesichert und kann durch leicht montierbare Sicherungssegmente axial fixiert werden.

Wenn vorzugsweise das Rad in seiner Formgebung und seinen Abmessungen im Anordnungsbereich der Bauteile einer Rotorscheibe entspricht oder gar eine ausrangierte Rotorscheibe einer Triebwerksstufe ist oder eine aus Billigwerkstoff hergestellte Musterrotorscheibe darstellt, so lassen sich besonders vorteilhaft Turbinenschaufeln mit Plattformoberseiten und/oder mit Unterseiten eines integralen Deckbandelementes in dieser derart modifizierten erfindungsgemäßen Vorrichtung in einem Arbeitsgangs beschichten.

In einer anderen bevorzugten Ausbildung der Erfindung ist das Rad ein flacher Hohlzylinder. Dieser flache Hohlzylinder hat den Vorteil, daß er auf seinem Mantelring beliebig gestaltete Aussparungen aufweisen kann, so daß beliebig gestaltete Bauteile partiell beschichtet werden können. Vorzugsweise entspricht der Hohlzylinder in seinen Außenmaßen einer Rotorscheibe, wenn Triebwerksschaufeln zu beschichten sind.

Eine Vorheizvorrichtung kann vorzugsweise außerhalb des aktiven Reaktionsraumes zur Vorwärmung benachbarter Bauteile der Bauteilgruppe angeordnet sein. Das hat den Vorteil, daß Kontaminationen der Beschichtungsquelle von vornherein ausgeschlossen werden, da Heizquelle und Beschichtungsquelle an unterschiedlichen Umfangspositionen des Rades angeordnet sind. Besonders bevorzugt wird eine Vorheizeinrichtung zur Trocknung, Vorwärmung oder Ausgasung der Bauteiloberflächen benachbarter Bauteile radialsymmetrisch gegenüber dem aktiven Reaktionsraum angeordnet, da hierbei die größte Entfernung zwischen Beschichtungsquelle und Heizquelle erreicht wird, was die Kontaminationsgefahr minimiert. Durch die räumliche Trennung von Beschichtungsquelle und Heizquelle können vorteilhaft Bauteile vorgewärmt werden, während gleichzeitig andere Bauteile in anderer Position auf dem Rad beschichtet werden. Wird in der Position der Vorheizeinrichtung zusätzlich eine Inertgas-Ionenquelle mit Ionenbeschleuniger angeordnet, so kann während der Vorheizung eine Ionenreinigung oder eine Ionenätzung der zu beschichtenden Oberflächen erfolgen.

Zur Verbesserung des Beschichtungsergebnisses und zur Vergleichmäßigung der Schichtdicke können vorzugsweise die Bauteile auf dem Radumfang drehbar um eine Bauteilachse angeordnet sein. Eine Drehung kann damit vorteilhaft kontinuierlich oder in Intervallen beim Beschichtungszyklus erfolgen, so daß die aus dem Rad herausragenden Oberflächen mehrfach und gleichmäßig beschichtet werden können.

Für Bauteile, die auch in radial außenliegenden Bereichen vor Beschichtung zu schützen sind, weist die Vorrichtung vorzugsweise einen an den radial äußeren Bauteilflächen anliegenden Abdeckring auf, wobei die zu schützenden Oberflächen vom Abdeckring abgedeckt werden. Besonders vorteilhaft läßt sich diese Vorrichtung einsetzen, wenn vorzugsweise die zu beschichtende Bauteilgruppe aus Triebwerksschaufeln mit Deckbandsegmenten besteht, wobei die radial äußeren Flächen der Deckbandsegmente einen Abdeckring aufweisen, so daß vorteilhaft nur das Schaufelblatt, die Oberseite der Plattform und die Unterseite des Deckbandsegments beschichtet werden können.

Vorzugsweise ist die Beschichtungsquelle ein in mindestens einer Raumrichtung bewegbarer Kathodenzerstäuber oder bewegbare Aufdampfquelle. Diese Raumrichtung kann sich radial von der Achse des Rades aus erstrecken, so daß mit relativ kleiner, auf die Größe des Zwischenraums zwischen zwei benachbarten Bauelementen begrenzter Strahlungsfläche des Kathodenzerstäubers oder der Aufdampfquelle, große Bauteilflächen durch radiale Verschiebung des Kathodenzerstäubers oder der Aufdampfquelle beschichtet werden können.

Eine weitere Verbesserung der Vorrichtung ist durch die Positionierung zweier sich gegenüberstehender Kathodenzerstäuber oder Aufdampfquellen erreichbar, da sich das Beschichtungsmaterial auf dem Kathodenzerstäuber oder auf der Aufdampfquelle nur in Randbereichen absetzt und im Bereich der jeweils gegenüberliegenden Strahlungsflächen unmittelbar in den aktiven Reaktionsraum wieder zurückgestrahlt wird, so daß sich die Strahlungsflächen gegenseitig von Beschichtungsmaterial freihalten.

Bei sphärich gekrümmten Bauteiloberflächen kann es von Vorteil sein, wenn vorzugsweise die Beschichtungsquelle ein um mindestens eine Raumachse schwenkbarer Kathodenzerstäuber oder eine schwenkbare Aufdampfquelle ist, da dann durch Schwenken des Kathodenzerstäubers oder der Aufdampfquelle diese der Krümmung der Bauteiloberfläche angepaßt werden kann, um gleichmäßige Beschichtungsdicken zu erhalten.

Das erfindungsgemäße Verfahren nach Anspruch 17 hat den Vorteil, daß die Bestückung eines Rades mit Bauteilen zur partiellen Beschichtung weniger zeitaufwendig ist als das Herstellen und montieren angepaßter Masken und Abschirmbleche oder das Schutzbeschichten der freizuhaltenden Bauteiloberflächen. Das Positionieren von zwei oder drei benachbarten Bauteilen in eine Abscheideposition oder Aufstäubeposition mittels eines kontinuierlichen Drehens des Rades oder mittels programmierbarer Schrittmotoren unter vorzugsweise taktweisem Drehen des Rades ist vorteilhaft und einfach durchführbar. Ein weiterer Vorteil besteht darin, daß beim Beschichtungszyklus relativ dicke Beschichtungen an den passiven, kleinflächigen Blenden entstehen, so daß eine Rückgewinnung des Beschichtungsmaterials wirtschatlich vertretbar wird.

Beim kontinuierlichen Drehen des Rades sind die Blenden für die axiale Begrenzung des aktiven Reaktionsraums so angeordnet, daß sich ihre Abdeckung über vier benachbarte Bauteilpositionen erstreckt, und dadurch beim Drehen zwei oder drei benachbarte Bauteile den aktiven Reaktionsraum seitlich begrenzen. Beim taktweisen Drehen reicht es vorteilhaft aus, wenn die Blenden für die axiale Begrenzung des aktiven Reaktionsraums so angeordnet sind, daß sich ihre Abdeckung lediglich über zwei benachbarte Bauteilpositionen erstreckt, solange beim Takten die Beschichtungsquelle ausgeschaltet bleibt.

Zur vollständigen Beschichtung aller Bauteile einer Bauteilgruppe muß bei der taktweisen Drehung des Rades das Rad um jeweils eine Bauteilposition pro Takt gedreht werden bis alle Bauteilpositionen eines Rades mindestens einmal durchgetaktet sind.

Bei einer bevorzugten Durchführung des Verfahrens werden während der Durchführung der Beschichtung die Bauteile um eine Bauteil achse gedreht. Das hat den Vorteil, daß unter Beibehaltung eines relativ kleinen und begrenzten aktiven Reaktionsraumes ein hohe gleichmäßige Beschichtungsqualität erreicht wird. Die Rotationsgeschwindigkeit um die Bauteilachse kann bei nicht rotationssymmetrischen Bauteilen zusätzlich innerhalb einer Drehung variiert und der Gestalt des Bauteils angepaßt sein.

Beim Beschichten werden vorzugsweise Edelmetalle aufgebracht, da sich beim Edelmetalaufsprühen, -aufstäuben oder -aufdampfen die wirtschaftlichen Vorteile der Erfindung besonders stark auswirken. Die Wirtschaftlichkeit einer Edelmetallrückgewinnung von Streubeschichtungen ist nämlich bereits bei geringen Schichtdicken gegeben. Vorzugsweise werden als Edelmetalle beim Beschichten Platin oder Legierungen desselben auf Triebwerksschaufeln aus Superlegierungen aufgebracht. Hier zeigt sich vorteilhaft, daß der aktive Reaktionsraum seitlich besonders günstig durch die Schaufelblätter begrenzt werden kann und Streuverluste an Platin, die nicht durch Rückgewinnung von Platinablagerungen auf Blenden ausgeglichen werden können, äußerst gering sind.

Ein bevorzugtes Verfahren zum Aufbringen der Beschichtung ist das Aufstäuben, bei dem unter vermindertem Druck und Bombardement von Inertgasionen auf eine zu zerstäubende Kathode das Kathodenmaterial abgetragen und auf die zu beschichtenden Oberflächen aufgebracht wird. Die Beschichtung kann vorzugsweise auch mittels Aufdampfen erfolgen. Dazu wird ein festes Quellmaterial mittels Laserstrahlverdampfung in einer Vorvakuum oder Hochvakuumkammer verdampft, wobei die Quelle erfindungsgemäß eine der Seitenwände des aktiven Reaktionsraumes bildet.

Die folgenden Figuren und das Beispiel sind Ausführungsformen der Erfindung, wobei
- Fig. 1: eine Vorrichtung zur partiellen Beschichtung von Bauteilen zeigt,
- Fig. 2: eine Triebwerksschaufel als Bauteil zeigt,
- Fig. 3: eine Draufsicht auf die Vorrichtung im Bereich des aktiven Reaktionsraumes zeigt, und
das Beispiel eine Verfahrensanwendung erläutert.

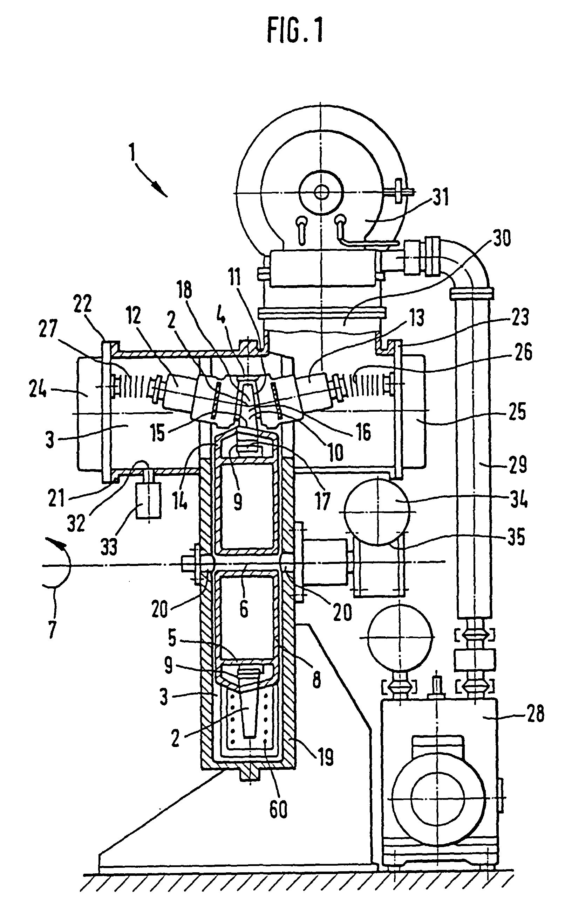

Fig. 1 zeigt eine Vorrichtung 1 zur partiellen Beschichtung von Bauteilen 2, die in einer Reaktionskammer 3 zu Bauteilgruppen angeordnet sind. Die nicht zu beschichtenden Bauteiloberflächen werden vor dem Beschichtungsmedium durch Blenden 4, 14 geschützt. Die Bauteile 2 sind auf dem Außenumfang 5 eines um seine Achse 6 in Pfeilrichtung 7 drehbaren Rades 8 angeordnet. Die nicht zu beschichtenden Oberflächen 9 der Bauteile 2 sind durch das Rad 8 verdeckt. Die zu beschichtenden Oberflächenbereiche 10 der Bauteile 2 ragen aus dem Rad 8 radial heraus. Dabei bilden jeweils zwei oder drei benachbarte Bauteile 2 der Bauteilgruppe zwei Seitenwände eines aktiven mit Beschichtungsmedium anreicherbaren Reaktionsraumes 11 aus zu beschichtenden Oberflächen 10 dieser Bauteile 2. Eine dritte Wand erstreckt sich entlang des Radumfangs 5 zwischen den benachbarten Bauteilen 2 und die verbleibenden drei Wände des aktiven Reaktionsraumes 11 werden von mindestens einer Beschichtungsquelle 12,13 und Blenden 4 gebildet. In diesem Beispiel werden zwei gegenüberliegende Beschichtungsquellen 12, 13 eingesetzt, die den aktiven Reaktionsraum 11 axial begrenzen, so daß diese Wände des aktiven Reaktionsraums 11 keine großen Blendenflächen erfordern, sondern im wesentlichen durch die Oberflächen der gegenüberliegenden Beschichtungsquellen 12, 13 eingenommen werden. Durch diese Anordnung wird das Beschichtungsmaterial der Beschichtungsquelle 12, das sich auf der Fläche der Beschichtungsquelle 13 absetzt, von dieser unmittelbar wieder zerstäubt oder verdampft und in den aktiven Reaktionsraum 11 zurückgestrahlt. Gleiches gilt für das Beschichtungsmaterial, das von der Beschichtungsquelle 13 ausgeht und sich auf der Beschichtungsquelle 12 absezt, so daß an diesen beiden axial begrenzenden Wänden des aktiven Reaktionsraums 11 geringe bis keine Streuverluste entstehen.

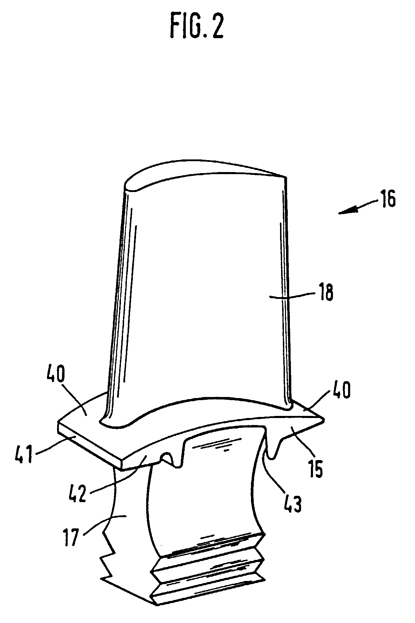

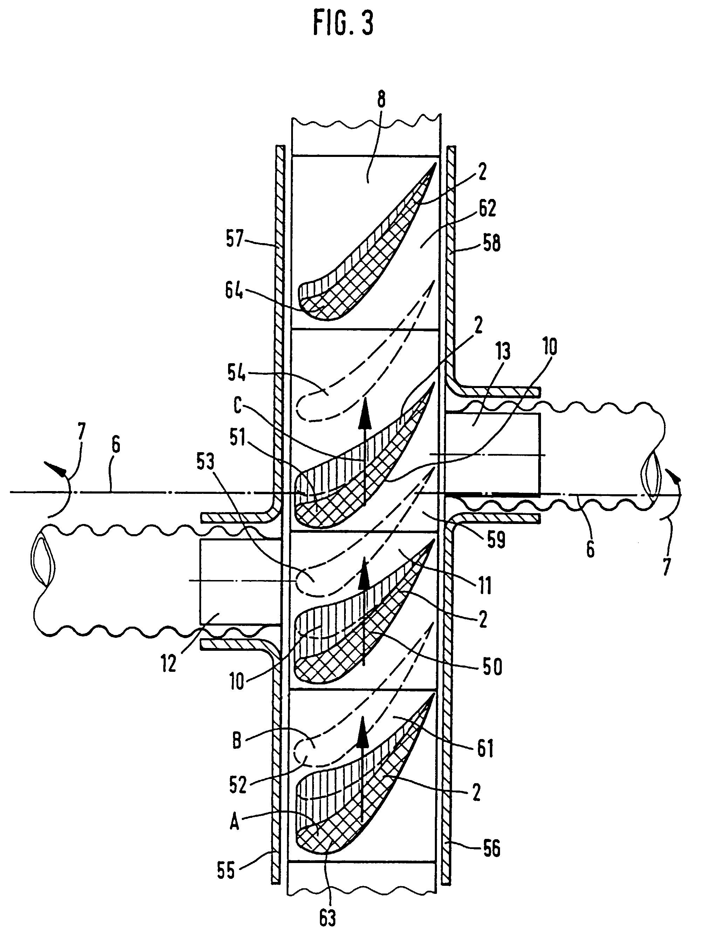

Die Bauteile 2 sind in diesem Beispiel Triebwerksschaufeln 16 mit einer Plattform 15, wie in Fig. 2 gezeigt. Diese Triebwerksschaufeln 16 können mit ihren Plattformen 15 zwischen Schaufelfuß 17 und Schaufelblatt 18 so dicht auf dem Radumfang angeordnet werden, daß die Plattformen 15 der Triebwerksschaufeln 16 eine geschlossene Umfangs- oder Mantelfäche auf dem Rad 8 bilden. Nach dem Positionieren der Schaufeln 16 im aktiven Reaktionsraum 11 bilden die äußeren Oberflächen der Plattformen 15 die dritte Wand als Boden des aktiven Reaktionsraums 11 aus wie es Fig. 3 zeigt, so daß in dieser beispielhaften Vorrichtung lediglich eine Streufläche durch die Blende 4 abzudecken ist. Damit wird das Verhältnis zwischen Nutzflächen und Streuflächen oder Blendenflächen äußerst günstig.

Die Reaktionskammer 3 besteht aus einem Gehäuse 19 für die Aufnahme des Rades 8 mit Drehdurchführungen 20 für die Achse 6 des Rades 8 und einem Beschichtungsgehäuse 21, das Flansche 22, 23 für die Aufnahmen von Deckeln 24, 25 aufweist, die die Beschichtungsquellen 12, 13 tragen und Durchführungen für die Energieversorgung und die mechanische Führung der Beschichtungsquellen 12, 13 über beispielsweise Faltenbalge 26, 27 aufweisen. Das Beschichtungsgehäuse 21 und das Gehäuse 19 können mittels einer Vorvakuumpumpe 28 über die Vakuumleitung 29 und die Öffnung 30 im Beschichtungsgehäuse 21 evakuiert werden. Zwischen Vakuumleitung 29 und Öffnung 30 kann eine Turbomolukularpumpe 31 zugeschaltet werden, mit der die Reaktionskammmer 3 auf ein Hochvakuum evakuiert werden kann. Zur Messung und Überwachung des Vakuums sind über die Öffnung 32 im Beschichtungsgehäuse 21 Vakuummeß- und -regelgeräte 33 an die Reaktionskammmer 3 angeflanscht.

Zur Vorwärmung und Vakuumreinigung der zu beschichtenden Oberflächen ist eine Heizvorrichtung 60 im Gehäuse 19 radialsymmetrisch zu den Beschichtungsquellen 12, 13 versetzt untergebracht.

Das Rad 8 wird mittels eines Motors 34 mit nachgeschaltetem Getriebe 35 über die Achse 6 angetrieben. Bei der Beschichtung von Triebwerksschaufeln 16, wie in Fig. 2 gezeigt, kommt es darauf an, daß nur die Oberflächen des Schaufelblattes 18 und die äußere Oberseite 40 der Plattform 15 beschichtet werden, während der Schaufelfuß 17 und die Seitenflächen 41, 42, sowie die Unterseite 43 der Plattform nicht zu beschichten sind. Da bei der erfindungsgemäßen Vorrichtung nur die Schaufelblätter 18 und die Oberseite 40 der Plattform 15 der Beschichtungsquelle 12, 13 ausgesetzt sind, bilden die aneinanderstoßenden Plattformen 15 die dritte Wand der aktiven Reaktionsraums 11 und die nicht zu beschichtenden Oberflächen 9 werden vom Rad 8 abgedeckt, besonders wenn das Rad 6 zur Aufnahme von Triebwerksschaufeln 16 auf dem Außenumfangsbereich Aussparungen aufweist, wie sie bei Rotorscheiben zur Aufnahme der Schaufelfüße 17 bekannt sind.

Fig. 3 zeigt eine Draufsicht auf die Vorrichtung nach Fig. 1 im Bereich des aktiven Reaktionsraumes 11. In dieser Ausführungsform der Erfindung sind die beiden Beschichtungsquellen 12, 13 axial gegenüberliegend aber radial versetzt angeordnet. Die Bauteile 2 werden in einer Grundposition A mit durchgezogenen Linien und in einer zeitlich und räumlich veränderten Position B mit gestrichelten Linien gezeigt. Die Pfeile C zeigen die Bewegungsrichtung des Rades, auf dessen Außenumfang die Bauteile montiert sind, an. Der aktive Beschichtungsraum wird in Position A von zwei benachbarten Bauteilen 50 und 51 begrenzt, wobei die zu beschichtenden Oberflächen 10 zwei Seitenwände des aktiven Reaktionsraumes 11 bilden. Dabei bilden zwei benachbarte Bauteile 63 und 50 mit den Blenden 55 und 56 eine Vorlaufkammer 61 und die benachbarten Bauteile 51 und 64 mit den Blenden 57 und 58 eine Nachlaufkammer 62, die wie Schleusen für den aktiven Reaktionsraum wirken. Damit wird gleichzeitig der aktive Reaktionsraum 11 in seiner Erstreckung auf dem Umfang des Rades 8 auf höchstens 3 benachbarte Bauteilpositionen begrenzt. In Positian B umfaßt der Reaktionsraum 11 den Zwischenraum zwischen drei derartig benachbarten Bauteilpositionen 52, 53 und 54, wobei die zu beschichtenden Oberflächen der Bauteile 52 und 54 die Seitenwände des aktiven Reaktionsraumes 11 bilden. Die langen Einlaufblenden 55 und 56 und die langen Auslaufblenden 57 und 58 sorgen dafür, daß bei kontinuierlicher Drehung des Rades 8 um seine Achse 6 in Pfeilrichtung 7 der aktive Reaktionsraum 11 geringe Wandflächen aufweist. Die Beschichtungsquellen 12 und 13 werden in dieser Ausführungsform von Kathodenzerstäubern gebildet, die Edelmetalle auf die zu beschichtenden Oberflächen 10 aufstäuben. In dieser besonderen Ausführungsform wird auch der Boden 59 des aktiven Reaktionsraums 11 von zu beschichtenden Oberflächen gebildet.

### Beispiel

Mit einem Beispiel wird die Anwendung des Verfahrens erläutert. Ein Rad 8, das einer Rotorscheibe nachgebildet ist, wird zur partiellen Beschichtung mittels Platin, mit Triebwerksschaufeln 16 so bestückt, daß die nicht zu beschichtenden Oberflächen der Schaufelfüße 17 durch das Rad 8 verdeckt werden und die zu beschichtenden Oberflächen der Schaufeln 16, die Schaufelblätter 18 aus dem Rad 8 radial herausragen. Danach werden die zu beschichtenden Oberflächen von zwei oder drei benachbarten Bauteilen zu Seitenwänden für einen aktiven Reaktionsraum 11 durch Drehen des Rades 8 um seine Achse 6 positioniert. Anschließend wird ein Beschichtungszyklus durchgeführt. Dazu werden die Bauteile in der Heizvorrichtung auf Temperaturen zwischen 200 °C und 700 °C aufgeheizt und über das Rad 8 an eine Spannung von 50 bis 200 V angeschlossen. Die Entladungsspannung für die Kathodenzerstäubung wird auf 200 bis 1000 V eingestellt und eine Zerstäubungsleistung von 10 bis 50 W/cm² bei einem Druck im Reaktionsraum von 0,1 bis 5 Pa gefahren, bis eine Platinschichtdicke auf den zu beschichtenden Oberflächen 10 von bis zu 2 µm erreicht ist. Die Bauteile werden dabei unter kontinierlichem Drehen des Rades 8 nacheinander durch den aktiven Reaktionsraum 11, in dem die Aufstäubung stattfindet, bewegt. Die Schichtdicke und Temperatur kann über entsprechende im aktiven Reaktionsraum 11 befindliche Meßsonden kontrolliert und eingestellt werden. Ein taktweises Durchfahren des aktiven Reaktionsraumes 11 bis alle Bauteile auf dem Rad 8 beschichtet sind ist ebenfalls möglich. Die Dauer eines solchen Beschichtungszyklus hängt von der Anzahl der Bauelemente einer Bauteilgruppe ab und liegt zwischen 5 Minuten und 5 Stunden.

Der Durchmesser des Rades 8 liegt zwischen 0,50 und 2m, während die Bauteiloberflächen, die radial aus dem Radumfang herausragen Längen von 50 bis 500 mm aufweisen. Die Radachse 6 kann zur Anpassung des Radumfangs an den aktiven Reaktionsraum 11 im Gehäuse 20 verschiebbar angeordnet sein.

## Patentansprüche

1. Vorrichtung zur partiellen Beschichtung von Bauteilen, die zu Gruppen in einer Reaktionskammer auf einem Drehteller mit Blenden so angeordnet sind, daß nicht zu beschichtende Bauteiloberflächen vor dem Beschichtungsmedium durch die Blenden geschützt sind, dadurch gekennzeichnet, daß die Bauteile (2) auf dem Außenumfang eines um seine horizontale Achse (6) drehbaren Rades (8) angeordnet sind, die nicht zu beschichtenden Oberflächen (9) der Bauteile (2) durch die Radscheibe verdeckt sind und die zu beschichtenden Oberflächenbereiche (10) der Bauteile (2) aus dem Rad (8) radial herausragen.

2. Vorrichtung nach Anspruch 1, dadurch gekennzeichnet, daß auf dem Außenumfang des Rades angeordnete benachbarte Bauteile (2) mit ihren einander zugewandten Oberflächen zwei Seitenwände eines aktiven mit Beschichtungsmedium anreicherbaren Reaktionsraumes (11) bilden, sich eine dritte Wand entlang des Radumfangs zwischen den benachbarten Bauteilen (2) erstreckt und die verbleibenden drei Wände des aktiven Reaktionsraumes (11) von mindestens einer Beschichtungsquelle (12,13) und Blenden (4,14) gebildet werden.

3. Vorrichtung nach Anspruch 1 oder 2, dadurch gekennzeichnet, daß die Radscheibe in ihrer Formgebung und ihren Abmessungen einer Rotorscheibe entspricht und die Bauteile (2) Schaufeln eines Rotors sind.

4. Vorrichtung nach einem der Ansprüche 1 bis 3, dadurch gekennzeichnet, daß eine Vorlaufkammer (61), die in Umlaufrichtung des Rades (11) vor dem aktiven Reaktionsraum (8) angeordnet ist, seitlich durch zwei weitere benachbarte Bauteile begrenzt wird und eine Nachlaufkammer (62), die sich in Umlaufrichtung an den aktiven Reaktionsraum anschließt, seitlich von zwei zusätzlichen benachbarten Bauteilen begrenzt wird und die verbleibenden drei Wände sowohl der Vorlauf und als auch der Nachlaufkammer von Blenden (55,56,57,58) gebildet werden.

5. Vorrichtung nach einem der Ansprüche 1 bis 4, dadurch gekennzeichnet, daß die dritte Wand zu beschichtende Oberflächen (10,40) der benachbarten Bauteile (2) teilweise oder vollständig bilden.

6. Vorrichtung nach einem der Ansprüche 1 bis 5, dadurch gekennzeichnet, daß mindestens eine der verbleibenden Wände des aktiven Reaktionsraumes (11) mindestens eine Heizquelle aufweist.

7. Vorrichtung nach einem der Ansprüche 1 bis 6, dadurch gekennzeichnet, daß auf mindestens einer der verbleibenden Wände des aktiven Reaktionsraumes (11) mindestens ein Meßfühler angeordnet ist.

8. Vorrichtung nach einem der Ansprüche 1 bis 7, dadurch gekennzeichnet, daß mindestens eine der verbleibenden Wände des aktiven Reaktionsraumes (11) mindestens eine Öffnung zur pyrometischen Temperaturerfassung aufweist.

9. Vorrichtung nach einem der Ansprüche 1 bis 8, dadurch gekennzeichnet, daß eine Vorheizvorrichtung (60) außerhalb des aktiven Reaktionsraumes (11) zur Vorwärmung benachbarter Bauteile (2) der Bauteilgruppe angeordnet ist.

10. Vorrichtung nach einem der Ansprüche 1 bis 9, dadurch gekennzeichnet, daß eine Vorheizeinrichtung (60) zur Trocknung, Vorwärmung oder Ausgasung der Bauteiloberflächen benachbarter Bauteile (2) radialsymmetrisch gegenüber dem aktiven Reaktionsraum (11) angeordnet ist.

11. Vorrichtung nach einem der Ansprüche 1 bis 10, dadurch gekennzeichnet, daß die Bauteile (2) auf dem Radumfang drehbar um eine Bauteil achse angeordnet sind.

12. Vorrichtung nach einem der Ansprüche 1 bis 11, dadurch gekennzeichent, daß die zu beschichtende Bauteilgruppe an ihren radial äußeren Bauteilflächen einen Abdeckring zum Schutz aufweist.

13. Vorrichtung nach einem der Ansprüche 1 bis 12, dadurch gekennzeichnet, daß die zu beschichtende Bauteilgruppe aus Triebwerksschaufeln (16) mit Deckbandsegmenten besteht und die radial äußeren Flächen der Deckbandsegmente einen Abdeckring zum Schutz vor Beschichtung aufweisen.

14. Vorrichtung nach einem der Ansprüche 1 bis 13, dadurch gekennzeichnet, daß die Beschichtungsquelle (12,13) ein in mindestens einer Raumrichtung bewegbarer Kathodenzerstäuber oder eine bewegbare Aufdampfquelle ist.

15. Vorrichtung nach einem der Ansprüche 1 bis 14, dadurch gekennzeichnet, daß die Beschichtungsquelle (12,13) ein um mindestens eine Raumachse schwenkbarer Kathodenzerstäuber oder eine schwenkbare Aufdampfquelle ist.

16. Vorrichtung nach einem der Ansprüche 1 bis 15, dadurch gekennzeichnet, daß die Beschichtungsquelle (12,13) ein um mindestens eine Raumachse schwenkbarer Kathodenzerstäuber oder eine schwenkbare Aufdampfquelle ist.

17. Verfahren zur partiellen Beschichtung von Bauteilgruppen aus Bauteilen, die zu Gruppen in einem Reaktionsraum mit Blenden so angeordnet sind, daß nicht zu beschichtende Oberflächen vor dem Beschichtungsmedium durch die Blenden geschützt sind, gekennzeichnet, durch folgende Verfahrensschritte
a) Bestücken eines Rades (8) mit Bauteilen (2), wobei die nicht zu beschichtenden Oberflächen (9) der Bauteile (2) durch das Rad (8) verdeckt werden und die zu beschichtenden Oberflächen (10) der Bauteile (2) aus dem Rad (8) radial herausragen,
b) Positionieren von zu beschichtenden Oberflächen (10) von zwei oder drei benachbarten Bauteilen (2) zu Seitenwänden für einen Reaktionsraum zwischen Blenden und Beschichtungsquellen, so daß ein aktiver mit Beschichtungsmedium anreicherbarer Reaktionsraum (11) ausgebildet wird,
c) Durchführen der Beschichtung unter Drehung des Rades (8) um seine Achse (6).

18. Verfahren nach Anspruch 17, dadurch gekennzeichnet, daß die Durchführung der Beschichtung taktweise unter Drehung des Rades (8) um jeweils eine Bauteilposition pro Takt erfolgt bis die Bauteilpositionen eines Rades (8) mindestens einmal durchgetaktet sind.

19. Verfahren nach Anspruch 17 oder 18, dadurch gekennzeichnet, daß während der Durchführung der Beschichtung die Bauteile (2) um eine Bauteilachse gedreht werden.

20. Verfahren nach einem der Ansprüche 17 bis 19, dadurch gekennzeichnet, daß beim Beschichten Edelmetalle aufgebracht werden.

21. Verfahren nach einem der Ansprüche 17 bis 20, dadurch gekennzeichnet, daß das Beschichten durch Aufstäuben erfolgt.

22. Verfahren nach einem der Ansprüche 17 bis 21, dadurch gekennzeichnet, daß das Beschichten durch Aufdampfen erfolgt.

23. Verfahren nach einem der Ansprüche 17 bis 22, dadurch gekennzeichnet, daß beim Beschichten vorzugsweise Platin oder Legierungen desselben auf Triebwerksschaufeln (16) aus Superlegierungen aufgebracht werden.

## Claims

1. An apparatus for the partial coating of components which are arranged in groups in a reaction chamber on a rotary plate with screens, in such a way that component surfaces not to be coated are protected from the coating medium by the screens, characterised in that the components (2) are arranged on the outer circumference of a wheel (8) rotatable about its horizontal axle (6), in that the surfaces not to be coated (9) of the components (2) are concealed by the wheel disk and in that the surface areas to be coated (10) of the components (2) radially project out from the wheel (8).

2. An apparatus according to daim 1, characterised in that adjacent components (2) arranged on the outer circumference of the wheel form, with their surfaces facing each other, two side walls of an active reaction space which can be enriched with coating medium, in that a third wall extends along the circumference of the wheel between the adjacent components (2), and in that the remaining three walls of the active reaction space (11) are formed by at least one coating source (12, 13) and screens (4, 14).

3. An apparatus according to daim 1 or 2, characterised in that the wheel disc, in its shaping and its dimensions, corresponds to a rotor disc and the components (2) are rotor blades.

4. An apparatus according to any one of claims 1 to 3, characterised in that a leading chamber which is arranged in front of the active reaction space (8), in the direction of rotation of the wheel (11), is limited at the sides by two further adjacent components and a trailing chamber (62) which is connected to the active reaction space in the direction of rotation, is limited at the sides by two additional adjacent components, and in that the remaining three walls of both the leading chamber and of the trailing chamber are formed by screens (55. 56, 57, 58).

5. An apparatus according to any one of claims 1 to 4, characterised in that surfaces to be coated (10, 40) of the adjacent components (2) partially or completely form the third wall.

6. An apparatus according to any one of claims 1 to 5, characterised in that at least one of the remaining walls of the active reaction space (11) has at least one heat source.

7. An apparatus according to any one of claims 1 to 6, characterised in that at least one sensor is arranged on at least one of the remaining walls of the active reaction space (11).

8. An apparatus according to any one of claims 1 to 7, characterised in that at least one of the remaining walls of the active reaction space (11) has at least one opening for pyromeric temperature detection.

9. An apparatus according to any one of claims 1 to 8, characterised in that a preheating device (60) is arranged outside the active reaction space (11) to preheat adjacent components (2) of the group of components.

10. An apparatus according to any one of claims 1 to 9, characterised in that a preheating device (60) for drying, preheating or fumigating the component surfaces of adjacent components (2) is arranged radially symmetrically opposed to the active reaction space (11).

11. An apparatus according to any one of claims 1 to 10, characterised in that the components (2) are arranged on the wheel circumference so as to be rotatable around a component axis.

12. An apparatus according to any one of claims 1 to 11, cnaracterised in that the group of components to be coated has a cover ring for protection on its radially outer component faces.

13. An apparatus according to any one of claims 1 to 12, characterised in that the group of components to be coated comprises engine blades (16) with cover band segments and in that the radially outer faces of the cover band segments have a cover ring for protection from coating.

14. An apparatus according to any one of claims 1 to 13, cnaracterised in that the coating source (12. 13) is a cathode evaporator movable spatially in at least one direction, or a movable evaporating source.

15. An apparatus according to any one of claims 1 to 14, characterised in that the coating source (12, 13) is a cathode evaporator which can be swivelled around at least one spatial axis or is an evaporating source which can be swivelled.

16. An apparatus according to any one of claims 1 to 15, characterised in that the coating source (12, 13) is a cathode evaporator which can be swivelled around at least one spatial axis or is an evaporating source which can be swivelled.

17. A process for the partial coating of components which are arranged in groups in a reaction space with screens in such a way that surfaces not to be coated are protected from the coating medium by the screens, characterised by the following process steps:
a) Providing a wheel (8) with components (2), where the surfaces not to be coated (9) of the components (2) are concealed by the wheel (8) and the surfaces to be coated (10) of the components (2) project out radially from the wheel (8),
b) Positioning surfaces to be coated (10) of two or three adjacent components (2) as side walls for a reaction space between screens and coating sources, so that an active reaction space (11) which can be enriched with coating medium is formed,
c) Carrying out the coating while rotating the wheel (8) around its axis (6).

18. A process according to claim 17, characterised in that the coating is carried out in pulses during rotation of the wheel (8) by one component position per pulse until the component positions of a wheel (8) have been through at least one cycle.

19. A process according to claim 17 or 18, characterised in that during the coating, the components (2) are rotated around a component axis.

20. A process according to any one of claims 17 to 19. characterised in that precious metals are applied during coating.

21. A process according to any one of daims 17 to 20, characterised in that the coating takes place by spraying.

22. A process according to any one of claims 17 to 21, characterised in that the coating takes place by evaporation.

23. A process according to any one of claims 17 to 22 characterised in that during coating, preferably platinum or alloys thereof are applied to engine blades (16) made of super-alloys.

## Revendications

1. Dispositif d'enduction partielle d'éléments de construction, qui sont disposés en groupe dans une chambre réactionnelle sur un plateau tournant avec des écrans, de façon que les surfaces des éléments à ne pas enduire soient protégées du milieu enducteur par les écrans,
caractérisé en ce que
les éléments de construction (2) sont disposés sur le pourtour d'une roue (8) mobile autour de son axe horizontal (6), les surfaces (9) à ne pas enduire des éléments de construction (2) sont protégées par le disque de roue et les zones superficielles (10) à enduire des éléments (2) dépassent radialement de la roue (8).

2. Dispositif selon la revendication 1,
caractérisé en ce que
des éléments de contraction (2) voisins disposés sur le pourtour extérieur de la roue forment avec leurs surfaces tournées l'une vers l'autre deux parois latérales d'un espace réactionnel (11) enrichi de milieu enducteur, une troisième paroi s'étend le long du pourtour de roue entre les éléments voisins (2) et les trois parois de l'espace réactionnel (11) sont constituées d'au moins une source d'enduction (12, 13) et d'écrans (4, 14).

3. Dispositif selon les revendications 1 ou 2,
caractérisé en ce que
le disque de roue correspond dans sa forme et ses dimensions à un disque de rotor et les éléments (2) sont des aubes d'un rotor.

4. Dispositif selon une des revendications 1 à 3,
caractérisé en ce qu'
une chambre préliminaire (61) qui est déposée dans le sens d'avancement de la roue (11) avant la chambre active réactionnelle (8), est limitée latéralement par deux autres éléments de construction voisines et une chambre postérieure (62), qui se raccorde dans le sens de marche à la chambre active de réaction, est limitée latéralement par deux éléments de construction additionnelle voisins et les trois parois restantes sont formées aussi bien celle préliminaire que la chambre postérieure par des écrans (55, 56, 57, 58).

5. Dispositif selon une des revendications 1 à 4,
caractérisé en ce que
la troisième paroi constitue des surfaces à enduire (10, 40) partiellement ou complètement des éléments (2) voisins.

6. Dispositif selon une des revendications 1 à 5,
caractérisé en ce qu'
au moins une des parois restantes de l'espace réactionnel actif (11) comporte au moins une source chauffante.

7. Dispositif selon une des revendications 1 à 6,
caractérisé en ce que
sur au moins une des parois restantes de l'espace réactionnel actif (11) est placé un capteur de mesure.

8. Dispositif selon une des revendications 1 à 7,
caractérisé en ce qu'
au moins une des parois restantes de l'espace réactionnel actif (11) comporte au moins une ouverture pour la prise de température pyrométrique.

9. Dispositif selon une des revendications 1 à 9,
caractérisé en ce qu'
un dispositif de préchauffage (60) est placé en dehors de la chambre réactionnelle active (11) pour préchauffer des éléments (2) voisins du groupe d'éléments.

10. Dispositif selon une des revendications 1 à 9,
caractérisé en ce qu'
un dispositif de préchauffage (60) est disposé pour le séchage, le préchauffage ou le dégazage des surfaces des éléments voisins (2), de manière radial symétrique par rapport à la chambre réactionnelle active (11).

11. Dispositif selon une des revendications 1 à 10,
caractérisé en ce que
les éléments de construction (2) sont disposés mobiles en rotation autour d'un axe d'élément sur le pourtour de la roue.

12. Dispositif selon une des revendications 1 à 11,
caractérisé en ce que
le groupe d'éléments de construction à enduire comporte sur ses surfaces d'éléments radialement extérieures un anneau d'enduction pour la protection.

13. Dispositif selon une des revendications 1 à 12,
caractérisé en ce que
le groupe d'éléments de construction à enduire se compose d'aubes (16) avec des segments de turbo propulseur de bandeaux de recouvrement et les surfaces radialement extérieures de segments de bandeau de recouvrement comportent un anneau d'enduction pour la protection contre l'enduction.

14. Dispositif selon une des revendications 1 à 13,
caractérisé en ce que
la source d'enduction (12, 13) est une pulvérisateur cathodique mobile au moins dans une direction spatiale ou une source de métallisation déplaçable.

15. Dispositif selon une des revendications 1 à 14,
caractérisé en ce que
la source d'enduction (12, 13) est un pulvérisateur cathodique pivotable autour d'au moins un axe spatial ou une source de métallisation pivotable.

16. Dispositif selon une des revendications 1 à 15,
caractérisé en ce que
la source d'enduction (12, 13) est un pulvérisateur cathodique pivotable au moins autour d'un axe spatial ou une source de métallisation pivotable.

17. Procédé pour enduction partielle de groupes d'éléments de contraction, qui sont disposés en groupes dans une chambre réactionnelle avec des écrans, de sorte que des surfaces à ne pas enduire sont protégées du milieu enducteur par les écrans,
caractérisé par les phases suivantes de procédé :
a) équipement d'une roue (8) avec des éléments de construction (2), tandis que les surfaces (9) à ne pas enduire des éléments (2) sont recouverts par la roue (8) et que les surfaces à enduire (10) des éléments (2) dépassent radialement de la roue (8),
b) positionnement des surfaces à enduire (10) de deux ou trois éléments (2) voisins par rapport aux parois latérales pour l'obtention d'une chambre réactionnelle entre écrans et sources d'enduction, de sorte qu'une chambre réactionnelle (11) active enrichie avec un milieu d'induction soit créée,
c) exécution de l'enduction en faisant tourner la roue (8) autour de son axe (6).

18. Procédé selon la revendication 17,
caractérisé en ce que
la réalisation de l'enduction a lieu cycliquement par rotation de la roue (8) autour respectivement d'une position d'élément par cycle jusqu'à ce que les positions des éléments d'une roue (8) soient soumises au cycle au moins une fois.

19. Procédé selon les revendications 17 ou 18,
caractérisé en ce que
pendant la réalisation de l'enduction, les éléments de construction (2) sont soumises à une rotation autour de l'axe de l'élément.

20. Procédé selon une des revendications 17 à 19,
caractérisé en ce que
lors de l'enduction sont appliqués des métaux nobles.

21. Procédé selon une des revendications 17 à 20,
caractérisé en ce que
l'enduction a lieu par pulvérisation.

22. Procédé selon une des revendications 17 à 21,
caractérisé en ce que
l'enduction a lieu par métallisation.

23. Procédé selon une des revendications 17 à 22,
caractérisé en ce que
lors de l'enduction on applique de préférence du platine ou de ses alliages sur des aubes de propulseur (16) du turbo propulseur constituées de superalliages.
